Europäisches Patentamt

(19) **European Patent Office**

Office européen des brevets

(11) Publication number: **0 082 189**
**B1**

(12) **EUROPEAN PATENT SPECIFICATION**

(45) Date of publication of patent specification: **13.04.88**

(51) Int. Cl.⁴: **B 05 D 3/06**

(21) Application number: **82902306.8**

(22) Date of filing: **17.06.82**

(86) International application number:
**PCT/US82/00818**

(87) International publication number:
**WO 83/00104 20.01.83 Gazette 83/02**

(54) MASKING PORTIONS OF A SUBSTRATE.

(30) Priority: **01.07.81 US 279290**

(43) Date of publication of application:
**29.06.83 Bulletin 83/26**

(45) Publication of the grant of the patent:
**13.04.88 Bulletin 88/15**

(84) Designated Contracting States:
**DE NL**

(56) References cited:
**GB-A-1 486 152**
**US-A-4 022 927**
**US-A-4 122 215**

**IBM Technical Disclosure Bulletin, issued 3.
August 1977, Fredericks et al., Polysulfone
Lift-Off Technique, vol. 20, no. 3, p. 989**

**IBM Technical Disclosure Bulletin, issued 8.
January 1978, Aalicki et al., Chrome-Copper-
Chrome Lift-Off Process, vol. 20, no. 8, p.
3080+3081**

**IBM Technical Disclosure Bulletin, issued 4.
September 1978, Bergeron, Double Lift-Off Via
Interconnection and Passivation, vol. 21, no. 4,
p. 1371+1372**

(73) Proprietor: **Western Electric Company,
Incorporated
222 Broadway
New York, NY 10038 (US)**

(72) Inventor: **HOLBROOK, Walter Raymond
Box 153J, R.D. 3
Reading, PA 19606 (US)**
Inventor: **SPONSLER, William Alexander
2552 Garfield Avenue
West Lawn, PA 19609 (US)**

(74) Representative: **Johnston, Kenneth Graham
et al
Western Electric Company Limited 5
Mornington Road
Woodford Green Essex, IG8 OTU (GB)**

Courier Press, Leamington Spa, England.

EP 0 082 189 B1

## Description

This invention relates to masking portions of a substrate. More particularly, the invention relates to removably masking at least one portion of a substrate to protect said portion during treatment such as irradiation of said substrate.

Masks of noble metals to protect portions of a substrate against processing agents, e.g., proton bombardment, have been applied and removed by different techniques. In one technique, a layer of chromiun is applied and a layer of gold is applied over the chromium and the gold is then selectively etched away by potassium iodide. A problem with such technique is that the removal of gold is troublesome because solutions which dissolve gold are often harmful to substrate materials. For example, potassiun iodide and aqua regia attack some substrates such as those containing gallium arsenide and others containing gallium phosphide. The above is described in U.S. Patent 3,824,133.

According to the present invention there is provided a method of processing a workpiece involving irradiating the workpiece through a radiation impenetrable masking layer for example of gold partly covering the surface of said workpiece and the removal of said masking layer after the processing step, said method characterized by applying to said workpiece a laminate comprising a first layer selected from nickel, aluminum, indium, or tin in contact with the workpiece overlaid by a second, masking layer selected from gold, platinum, palladium, irridium, lead or tungsten, and, after the processing step, separating said laminate from said workpiece by detaching said first layer from said workpiece.

## Brief Description of the Drawing

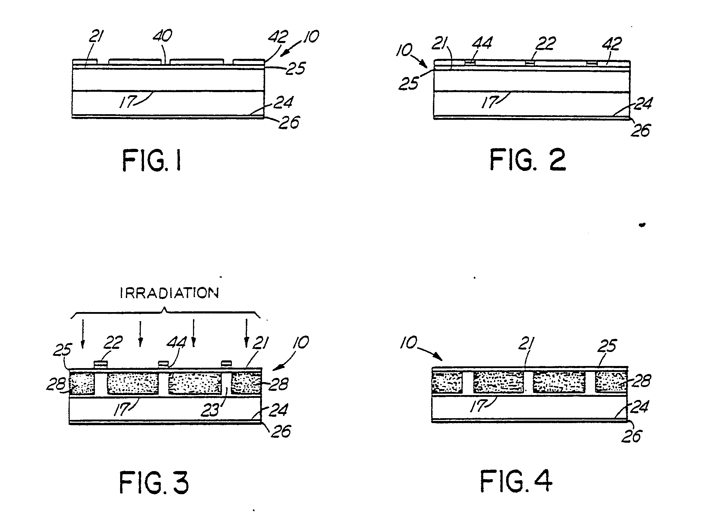

FIGS. 1—4 are side views of a workpiece showing successive steps in the practice of this invention.

## Detailed Description

While the present invention is useful in connection with the use of masking layers in general, it has particular utility with masking layers used with processing techniques involving radiation treatments, e.g., the known use of proton bombardments of semiconductor substrates. Masking materials which resist radiation are typically difficult to remove from a substrate because many such materials include the heavier and/or more noble metals, e.g., gold (the generally preferred material), and other, less widely used metals such as lead, tungsten, platinum, palladium, and irridium. If the metals are to be removed by dissolution thereof, harsh chemicals are often required which sometimes attack one or more materials in a substrate. Consequently, it is desirable to remove such masks without employing a solvent for the materials of the mask.

Masks of gold are particularly advantageous for radiation treatment because gold is a dense metal which is readily applied to a substrate by evaporation or by plating and a thin layer is highly resistant to penetration. Consequently, it is desirable to remove a layer of gold from a substrate without having to dissolve the gold.

The present invention can be used in the masking of substrates of a wide variety of materials. The greatest utility of the invention, at present, is with known substrates including such materials as gallium-phosphide, gallium-arsenide, indium-gallium-arsenide, and indium-gallium-aluminum-arsenide, such materials having various known dopants and used in various known combinations. Although of lesser utility, because known techniques are generally acceptable, the invention can be used with substrates of silicon, germanium, and gadolinium-gallium-garnet, as well as other known substrate materials.

### Example 1

By way of example of the practice of the invention, there is shown in FIG. 1 a substrate 10 of a semiconductor material, e.g., gallium-arsenide, including a p-n junction 17 therein and having metal layers 25 and 26 on opposite sides thereof. The layer 26 can comprise, for example, a composite material of tin, palladium and gold, and the layer 25 can comprise, for example, chromium or successive layers of titanium covered by platinum.

For the purpose of masking portions of the substrate 10 against later applied processing agents, e.g., bombardment of the workpiece by protons, a layer 42 of photoresist material is applied, by known process, over the layer 25. The layer 42 has openings 40 therethrough exposing the underlying layer 25. The openings 40 overlie and correspond with regions, e.g., current channels, desired to be formed in the substrate 10 by forming subsurface regions of high resistivity between the current channels. FIG. 2 shows the openings 40 after a parting layer 44 and stripes of a mask 22 have been applied therein (as described hereinafter). Thereafter (FIG. 3), the remaining photoresist layer 42 is removed.

The material for mask 22 is one which adheres to a parting layer 44 and which is substantially impenetrable by the intended treatment process. For low energy radiation comprising inter alia, x-rays, U.V. light and gamma rays, the mask can be any of a variety of known materials, such as lead. For high energy radiation comprising, inter alia, bombardment with protons or deuterium, the mask material advantageously is a noble metal such as tungsten or gold. As known, gold, in particular, serves as an excellent masking material for both low and high energy radiation as well as for other non-radiation treatment.

The interaction between chemicals, metals, substrates and processes as described herein is often said to be without harm or harmless to a specific component. It is to be understood, however, that such expression does not mean that there is no transformation in the unharmed component; it does indicate that any such transformation is of no substantial consequence in the work and, therefore, can be considered to be harmless.

The material for layer 44 should be adherent and harmless to the substrate 10 and the mask material. Once installed, layer 44 should also be substantially resistant to conditions occurring during the treatment process. Such conditions include but are not limited to, generation of heat, ion scattering, radiation and in particular, attack upon the thin edges of the layer which are exposed to the treatment.

A primary function of layer 44 is to serve as a sacrificial layer when the overlying mask 22 is to be removed. Layer 44 is referred to as a parting layer because it enables the substrate to part with the mask without necessarily treating the substrate or mask itself either chemically or physically.

To achieve the parting function in this example, nickel is used for layer 44. For proton bombardment of the substrate of GaAs, a thickness of about 5—10,000Å of nickel is applied to the portion of layer 25 exposed through the openings 40 using for example, a known electroplating process. The nickel adheres well to the layer 25, as well as to any portions of the GaAs substrate 10 exposed through the (thin) layer 25. The substrate 10 is sufficiently resistant to a conventional nickel sulfamate plating process for applying substantially stress-free nickel to a substrate. Furthermore, such a layer of nickle is receptive to a wide variety of possible masking materials.

After the nickel is applied, stripes of a material and a thickness suitable for the nickel and the radiation are applied thereon to form mask 22. Gold is advantageously selected and preferably electroplated upon the nickel layer 44 by a conventional potassium gold cyanide process. The process is harmless to the GaAs substrate 10 and the nickel layer 22 and provides a substantially stress-free and adherent layer 22 of gold upon the nickel layer 44. A thickness, for example, of about 25,000Å of gold is applied upon the nickel to provide adequate protection from the proton radiation.

After the photoresist layer 42 is removed, the substrate 10 containing mask 22 over layer 44 is irradiated as illustrated in FIG. 3. Regions 28 of high resistivity are created to define with accuracy the current channels 23, particularly in the area of the p-n junction 17.

After the irradiation treatment, the parting layer 44 and the gold mask therewith are removed from substrate 10 to obtain the condition shown in FIG. 4. Such removal is advantageously achieved by treating the parting layer 44 to detach it and the mask from substrate 10. The treatment of the parting layer can be chemical and mechanical and should take into account any vulnerability of GaAs substrate 10 to such treatment.

For the illustrative example shown in FIG. 3, substrate 10 was immersed in an aqueous solution of hydrochloric acid at room temperature. The acid was A.C.S. grade (35—1/2%—38% assay) and ultrasonic agitation was applied without mechanical abrasion of the mask to achieve detachment. The parting layer 44 along with the mask 28 became detached from the substrate in about 4 minutes after immersion. The substrate 10 was then immersed in a flowing rinse of deionized water for about 5 minutes which was sufficient to remove the acid and any particles of nickel or gold.

### Example No. 2

A parting layer 44 of the metal aluminum was applied about 5—10,000Å thick to openings 40 on a substrate 10 by electron gun evaporation. The aluminum adhered well to the Ti-Pt layer 25 of the substrate and was receptive to a gold mask 22 which was electroplated thereupon to a thickness of about 25,000Å.

After irradiation, the substrate 10 was immersed in a solution at room temperature containing the following constituents by volume: 85% phosphoric acid (85% minimum assay), 5% nitric acid (69—71% assay), 5% glacial acetic acid (min. 99.7% assay) and 5% water. The reaction time to adequately detach the aluminum parting layer 44 from substrate 10 was about 2—1/2 minutes with ultrasonic agitation and no mechanical abrasion. The substrate 10 was then immersed in a flowing water rinse for about 10 minutes to remove the detaching solution and any particles of aluminum or gold.

### Example No. 3

A parting layer 44 of the metal tin was applied about 5—10,000Å thick to openings 40 on a substrate 10 by electroplating. The tin was applied utilizing a conventional tin cyanide plating process. The tin adhered well to Ti-Pt layer 25 of the substrate and was receptive to a gold mask 22 which was electroplated thereupon to a thickness of about 25,000Å.

After irradiation, the substrate 10 was immersed in a solution at room temperature containing the following constituents by volume: 98% hydrochloric acid (36—1/2% to 38% assay) and 2% hydrogen peroxide (29—32% assay). The reaction time to adequately detach the tin parting layer 44 from substrate 10 was about 6 minutes with ultrasonic agitation and no mechanical abrasion. The substrate 10 was then immersed in a flowing water rinse for about 10 minutes.

### Example No. 4

Indium was applied on a substrate 10 utilizing a known sintering process. Alternately, the indium can be applied using a conventional indium fluorobate process.

The substrate 10 was immersed in a solution at room temperature containing A.C.S. grade hydrochloric acid without agitation. The reaction time to completely remove the thick indium layer was about 1/2 hour. A thin (5—10,000Å) layer of indium under gold is removed in about 5—15 minutes.

## Claims

1. A method of processing a workpiece (10) involving irradiating the workpiece through a radiation impenetrable masking layer (22) for example of gold partly covering the surface of said workpiece and the removal of said masking layer after the processing step, said method characterized by applying to said workpiece a laminate comprising a first layer (44) selected from nickel, aluminum, indium, or tin in contact with the workpiece overlaid by a second, masking layer (22) selected from gold, platinum, palladium, irridium, lead or tungsten, and, after the processing step, separating said laminate from said workpiece by detaching said first layer from said workpiece.

2. A method as in claim 1 wherein the masking layer is gold and the first layer is nickel.

3. A method as in claim 1, wherein the workpiece includes gallium arsenide, the first layer is nickel, and said detaching step comprises immersing the workpiece in hydrochloric acid.

4. A method as in claim 1, wherein the workpiece includes gallium arsenide, the first layer is aluminum, said detaching step comprises immersing the workpiece in a bath comprising, by volume, about 85% phosphoric acid, about 5% nitric acid, about 5% acetic acid and about 5% water.

5. A method as in claim 1, wherein the workpiece includes gallium arsenide, the first layer is indium, and said detaching step comprises immersing the workpiece in hydrochloric acid.

6. A method as in claim 1, wherein the workpiece includes gallium arsenide, the first layer is tin, and said detaching step comprises immersing the workpiece in a bath comprising by volume, about 98% hydrochloric acid and about 2% hydrogen peroxide.

## Patentansprüche

1. Verfahren zum Bearbeiten eines Werkstücks (10), umfassend
— Bestrahlen des Werkstückes durch eine strahlungsundurchlässige Maskierschicht (22), zum Beispiel aus Gold, die die Oberfläche des Werkstücks teilweise bedeckt und
— Entfernen der Maskierschicht nach dem Bearbeitungsschritt,
dadurch gekennzeichnet, daß
— auf das Werkstück ein Laminat aufgebracht wird, das eine erste, mit dem Werkstück in Berührung stehende, aus Nickel, Aluminium, Indium oder Zinn ausgewählte Schicht (44) und eine darüberliegende zweite, maskierende und aus Gold, Platin, Palladium, Iridium, Blei oder Wolfram ausgewählte Schicht (22) aufweist, und
— nach dem Bearbeitungsschritt das Laminat von dem Werkstück durch Ablösen der ersten Schicht vom Werkstück separiert wird.

2. Verfahren wie nach Anspruch 1, bei dem
— die Maskierschicht Gold ist und
— die erste Schicht Nickel ist.

3. Verfahren wie nach Anspruch 1, bei dem
— das Werkstück Galliumarsenid umfaßt,
— die erste Schicht Nickel ist und
— der Ablösungsschritt ein Eintauchen des Werkstücks in Chlorwasserstoffsäure umfaßt.

4. Verfahren wie nach Anspruch 1, bei dem
— das Werkstück Galliumarsenid umfaßt,
— die erste Schicht Aluminium ist und
— der Ablösungsschritt ein Eintauchen des Werkstückes in ein Bad umfaßt, das — je in Volumprozent — etwa 85% Phosphorsäure, etwa 5% Salpetersäure, etwa 5% Essigsäure und etwa 5% Wasser enthält.

5. Verfahren wie nach Anspruch 1, bei dem
— das Werkstück Galliumarsenid umfaßt,
— die erste Schicht Indium ist und
— der Ablösungsschritt ein Eintauchen des Werkstückes in Chlorwasserstoffsäure umfaßt.

6. Verfahren wie nach Anspruch 1, bei dem
— das Werkstück Galliumarsenid umfaßt,
— die erste Schicht Zinn ist und
— der Ablösungsschritt ein Eintauchen des Werkstückes in ein Bad umfaßt, das — je in Volumprozent — etwa 98% Chlorwasserstoffsäure und etwa 2% Wasserstoffperoxid enthält.

## Revendications

1. Un procédé de traitement d'un article (10) comprenant les opérations qui consistent à irradier l'article à travers une couche de masquage arrêtant le rayonnement (22), par exemple en or, qui recouvre partiellement la surface de l'article, et à enlever la couche de masquage après l'opération de traitement, ce procédé étant caractérisé en ce qu'on applique à l'article une structure multicouche comprenant une première couche (44) en une matière sélectionnée parmi le nickel, l'aluminium, l'indium ou l'étain, en contact avec l'article et recouverte par une seconde couche ou couche de masquage (22), en une matière sélectionnée parmi l'or, le platine, le palladium, l'irridium, le plomb ou le tungstène, et après l'opération de traitement, on sépare la structure multicouche de l'article, en détachant la première couche de l'article.

2. Un procédé selon la revendication 1, dans lequel la couche de masquage est en or et la première couche est en nickel.

3. Un procédé selon la revendication 1, dans lequel l'article comprend de l'arséniure de gallium, la première couche est en nickel et l'opération de détachement comprend l'immersion de l'article dans de l'acide chlorhydrique.

4. Un procédé selon la revendication 1, dans lequel l'article comprend de l'arséniure de gallium, la première couche est en aluminium et l'operation de détachement comprend l'immersion de l'article dans un bain comprenant, en volume, environ 85% d'acide phosphorique, environ 5% d'acide nitrique, environ 5% d'acide acétique et environ 5% d'eau.

5. Un procédé selon la revendication 1, dans lequel l'article comprend de l'arsénuire de gallium, la première couche est en indium et l'opération de détachement comprend l'immersion de l'article dans de l'acide chlorhydrique.

6. Un procédé selon la revendication 1, dans lequel l'article comprend de l'arséniure de gallium, la première couche est en étain et l'opération de détachement comprend l'immersion de l'article dans un bain comprenant, en volume, environ 98% d'acide chlorhydrique et environ 2% de peroxyde d'hydrogène.

FIG. I

FIG. 2

IRRADIATION

FIG. 3

FIG. 4